# EUROPÄISCHE PATENTANMELDUNG

(11) **EP 4 576 211 A1**
(43) Veröffentlichungstag der Anmeldung: **25.06.2025**
(21) Anmeldenummer: 23217829.3
(22) Anmeldetag: 19.12.2023
(51) Int. Cl.: H01L 25/07, H01L 23/053

(54) **HALBLEITERMODUL MIT EINER HALBLEITERSCHALTUNG UND EINEM GEHÄUSE**

(71) Anmelder: Siemens Aktiengesellschaft, 80333 München (DE)
(72) Erfinder: Kneißl, Philipp, 90427 Nürnberg (DE); Lorz, Roland, 91341 Röttenbach (DE); Ye, Yijun, 91056 Erlangen (DE); Zeyß, Felix, 91052 Erlangen (DE)
(74) Vertreter: Siemens Patent Attorneys

(57) **Zusammenfassung**

Die Erfindung betrifft ein Halbleitermodul (2) aufweisend eine Halbleiterschaltung (34) und ein Gehäuse (4), welches eine Wärmesenke (6) umfasst, wobei das Gehäuse (4), die Halbleiterschaltung (34) zumindest teilweise umgibt, wobei die Halbleiterschaltung (34) zumindest ein Substrat (36, 38), welches auf einer ebenen Oberfläche (7) der Wärmesenke (6) angeordnet ist, Halbleiterelemente (46), welche auf dem zumindest einen Substrat (36, 38) kontaktiert sind, aufweist. Um ein möglichst flexibles Halbleitermodul (2) anzugeben, das hohe Schaltfrequenzen und Leistungsdichten ermöglicht, wird vorgeschlagen, dass Kontaktelektroden (12, 16, 20, 14, 18, 22) mit der Halbleiterschaltung (34) verbunden und jeweils durch eine Gehäuseausnehmung (24) in einer Deckfläche (10) des Gehäuses (4) nach außen geführt sind, wobei die Kontaktelektroden (12, 16, 20, 14, 18, 22) jeweils einen zumindest teilweise nach außen geführten Kontaktierungsabschnitt (26), einen Mittelabschnitt (50) und einen mit dem Substrat (36, 38) verbindbaren Verbindungsabschnitt (52) aufweisen, wobei der Verbindungsabschnitt (52) der jeweiligen Kontaktelektrode (12, 16, 20, 14, 18, 22) durch translatorisches Biegen des Kontaktierungsabschnitts (26) und Verbindungsabschnitts (52) zum jeweiligen Mittelabschnitt (50) bei fixer Positionierung zur Gehäuseausnehmung (24) mit vier, insbesondere rechteckförmig angeordneten, Kontaktflächen (54) auf dem Substrat (36, 38) verbindbar ist.

## Beschreibung

Die Erfindung betrifft ein Halbleitermodul aufweisend eine Halbleiterschaltung und ein Gehäuse, welches eine Wärmesenke umfasst,
Ferner betrifft die Erfindung einen Stromrichter mit mindestens einem derartigen Halbleitermodul.

Überdies betrifft die Erfindung ein Verfahren zur Herstellung eines derartigen Halbleitermoduls.

Darüber hinaus betrifft die Erfindung ein Computerprogrammprodukt, umfassend Befehle, die bei einer Ausführung des Programms durch einen Computer diesen veranlassen, ein Verhalten eines derartigen Halbleitermoduls zu simulieren.

Ein derartiges Halbleitermodul kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die im Halbleitermodul zum Einsatz kommenden Halbleiterelemente sind unter anderem Transistoren und Dioden. Transistoren sind beispielsweise als Insulated-Gate-Bipolar-Transistoren (IGBTs) oder als Wide-Bandgap-Transistoren ausgeführt. Die Wide-Bandgap-Transistoren können beispielsweise in Siliziumcarbid- oder Galliumnitrid-Technologie realisiert sein und ermöglichen unter anderem höhere Schaltfrequenzen.

Die Offenlegungsschrift EP 4 173 039 A1 beschreibt ein Leistungshalbleitermodul, das eine Leistungshalbleiterschaltung und ein Gehäuse aufweist, wobei das Gehäuse die Leistungshalbleiterschaltung wenigstens teilweise umgibt, und wobei die Leistungshalbleiterschaltung eine erste Kontaktelektrode und eine zweite Kontaktelektrode aufweist, die jeweils mit der Leistungshalbleiterschaltung elektrisch leitend verbunden sind, und die jeweils durch eine hierfür ausgebildete Ausnehmung in dem Gehäuse durch das Gehäuse nach außen geführt sind.

Die Offenlegungsschrift EP 4 233 165 A1 beschreibt einen Stromrichter mit mindestens zwei, insbesondere gleichartigen, Leistungshalbleitermodulen. Um, im Vergleich zum Stand der Technik, eine höhere Zuverlässigkeit zu erreichen, wird vorgeschlagen, dass die Leistungshalbleitermodule jeweils zumindest einen Leistungshalbleiter und Leistungskontakte aufweisen, wobei die Leistungshalbleiter elektrisch leitend mit den Leistungskontakten des jeweiligen Leistungshalbleitermoduls verbunden sind.

Die Offenlegungsschrift WO 2023/147910 A1 beschreibt eine Anordnung für eine Halbleiteranordnung mit mindestens einem passiven Bauelement und einem Substrat, wobei das Substrat eine dielektrische Materiallage und eine auf der dielektrische Materiallage angeordnete erste Metallisierung aufweist.

Um die Leistungsfähigkeit eines Halbleitermodules zu erhöhen, werden üblicherweise mehrere Halbleiterelemente parallelgeschaltet. Mit zunehmender Modulgröße sind für ein optimiertes Layout eine Mehrzahl von Randbedingungen zu betrachten, wobei ein guter Kompromiss zwischen verschiedenen Optimierungszielen zu finden ist. Mit zunehmend höheren Schaltfrequenzen und Leistungsdichten spielen die Aufteilung der Halbleiterelemente und deren Kontaktierung eine immer größere Rolle. Gleichzeitig sollen möglichst viele Schaltungstopologien und deren Varianten in einem flexiblen standardisierten Gehäuse untergebracht werden.

Vor diesem Hintergrund besteht die Aufgabe der vorliegenden Erfindung darin, ein möglichst flexibles Halbleitermodul anzugeben, das hohe Schaltfrequenzen und Leistungsdichten ermöglicht.

Die Aufgabe wird erfindungsgemäß gelöst durch ein Halbleitermodul aufweisend eine Halbleiterschaltung und ein Gehäuse, welches eine Wärmesenke umfasst, wobei das Gehäuse, die Halbleiterschaltung zumindest teilweise umgibt, wobei die Halbleiterschaltung zumindest ein Substrat, welches auf einer ebenen Oberfläche der Wärmesenke angeordnet ist, Halbleiterelemente, welche auf dem zumindest einen Substrat kontaktiert sind, aufweist, wobei Kontaktelektroden mit der Halbleiterschaltung verbunden und jeweils durch eine Gehäuseausnehmung in einer Deckfläche des Gehäuses nach außen geführt sind, wobei die Kontaktelektroden jeweils einen zumindest teilweise nach außen geführten Kontaktierungsabschnitt, einen Mittelabschnitt und einen mit dem Substrat verbindbaren Verbindungsabschnitt aufweisen, wobei der Verbindungsabschnitt der jeweiligen Kontaktelektrode durch, insbesondere translatorisches, Biegen des Kontaktierungsabschnitts und Verbindungsabschnitts zum jeweiligen Mittelabschnitt bei fixer Positionierung zur Gehäuseausnehmung mit vier, insbesondere rechteckförmig angeordneten, Kontaktflächen auf dem Substrat verbindbar ist.

Ferner wird die Aufgabe erfindungsgemäß gelöst durch einen Stromrichter mit mindestens einem derartigen Halbleitermodul.

Überdies wird die Aufgabe erfindungsgemäß gelöst durch ein Verfahren zur Herstellung eines derartigen Halbleitermoduls, wobei die Kontaktelektroden als metallische Biegeteile ausgeführt und mit einem gemeinsamen Stanzwerkzeug hergestellt werden.

Darüber hinaus wird die Aufgabe erfindungsgemäß gelöst durch ein Computerprogrammprodukt, umfassend Befehle, die bei einer Ausführung des Programms durch einen Computer diesen veranlassen, ein, insbesondere thermisches, mechanisches und/oder elektrisches, Verhalten eines derartigen Halbleitermoduls zu simulieren.

Die in Bezug auf das Halbleitermodul nachstehend angeführten Vorteile und bevorzugten Ausgestaltungen lassen sich sinngemäß auf den Stromrichter, das Verfahren und das Computerprogrammprodukt übertragen.

Der Erfindung liegt die Überlegung zugrunde, Kontaktelektroden eines Halbleitermoduls so auszuführen, dass diese in einem, insbesondere standardisierten, Gehäuse möglichst flexibel auf einem Substrat kontaktierbar sind, um hohe Schaltfrequenzen und Leistungsdichten zu ermöglichen. Ein derartiges Halbleitermodul kann unter anderem ein Leistungshalbleitermodul mit einer Leistungshalbleiterschaltung, welche von einem Gehäuse zumindest teilweise umgeben ist, sein. Eine derartige Leistungshalbleiterschaltung weist auf zumindest einem Substrat angeordnete Leistungshalbleiterelemente, insbesondere Transistoren und Dioden, auf. Das zumindest eine Substrat, welches unter anderem als DCB (Direct Copper Bonded) Substrate ausgeführt sein kann, ist auf einer ebenen Oberfläche einer Wärmesenke, welche beispielsweise eine metallische Grundplatte aufweist, angeordnet. Die Kontaktelektroden sind mit der Halbleiterschaltung verbunden, wobei jeweils ein Kontaktierungsabschnitt zumindest teilweise durch eine Gehäuseausnehmung in einer Deckfläche des Gehäuses nach außen geführt ist. Die Kontaktelektroden weisen neben dem Kontaktierungsabschnitt einen Mittelabschnitt und einen mit dem Substrat verbindbaren Verbindungsabschnitt auf. Der Kontaktierungsabschnitts und der Verbindungsabschnitts werden bei fixer Positionierung zur Gehäuseausnehmung jeweils, insbesondere translatorisch, zum jeweiligen Mittelabschnitt gebogen, wobei in diesem Zusammenhang unter translatorischem Biegen ein linearer Biegevorgang um eine geradlinig verlaufende Biegeachse zu verstehen ist. Beispiele für translatorisches Biegen sind unter anderem Zieh-Biegen und Gesenk-Biegen. Die fixe Positionierung der Kontaktelektrode, insbesondere des Mittelabschnitts der Kontaktelektrode, zur Gehäuseausnehmung ermöglicht unter anderem die Anordnung in einem standardisierten Gehäuse. Durch einen derartigen Biegevorgang ist der Verbindungsabschnitt jeweils mit vier, insbesondere rechteckförmig angeordneten, Kontaktflächen auf dem Substrat verbindbar. Somit ist die Kontaktelektrode flexibel auf dem Substrat kontaktierbar und es ergeben sich Freiheitsgrade für das Layout, sodass beispielsweise Zuleitungsinduktivitäten verringert und damit Schaltfrequenzen erhöht werden können. Ferner ergeben sich durch Flexibilisierung des Layouts Möglichkeiten, die Leistungshalbleiterschaltung so zu optimieren, dass höhere Leistungsdichten erreichbar sind.

Die Kontaktelektroden, die aus einem metallischen Biegeteil, insbesondere einem Metallblech, hergestellt werden, werden mit einem Stanzwerkzeug hergestellt, was Kosten einspart.

Ein Computerprogrammprodukt, welches Befehle umfasst, die bei einer Ausführung des Programms durch einen Computer diesen veranlassen, ein, insbesondere thermisches, mechanisches und oder elektrisches, Verhalten der beschriebenen Halbleiteranordnung zu simulieren kann einen "digitalen Zwilling", auch "digital twin" genannt, umfassen oder als ein solcher ausgebildet sein. Ein derartiger digitaler Zwilling ist beispielsweise in der Offenlegungsschrift US 2017/0286572 A1 dargestellt. Der Offenbarungsgehalt von US 2017/0286572 A1 wird durch Verweisung in die vorliegende Anmeldung mit einbezogen. Der "digitale Zwilling" ist beispielsweise eine digitale Repräsentanz der für den Betrieb der Halbleiteranordnung relevanten Komponenten. Insbesondere verfügt das Computerprogramm über ein Physik-Modul, in dem das Halbleitermodul mit der Leistungshalbleiterschaltung zumindest teilweise abgebildet wird und zumindest das elektrische und/oder thermische Verhalten von den abgebildeten Teilen des Halbleitermoduls unter einstellbaren Betriebsbedingungen und/oder Parametern, wie beispielsweise einer Anordnung der Halbleiterelemente, welche nach einem, insbesondere nicht-linearen, Modell nachgebildet sind, und/oder Konfiguration der Kontaktelektroden nachstellt. Die abgebildeten Teile des Halbleitermoduls können unter anderem eine Temperaturverteilung auf dem Substrat bzw. der Wärmesenke aufweisen, die im Wesentlichen einer Temperaturverteilung während des Betriebes des realen Halbleitermoduls entspricht, wobei z.B. eine Umgebungstemperatur und ein Lastspiel zu den einstellbaren Betriebsbedingungen gehören. Unter Berücksichtigung der Umgebungstemperatur und des Lastspiels kann in diesem Fall die Temperaturverteilung ausgegeben werden. Zusätzlich oder alternativ können die abgebildeten Teile des Halbleitermoduls parasitäre Impedanzen, z.B. parasitäre Widerstände und/oder Induktivitäten, aufweisen, die im Wesentlichen den parasitären Impedanzen während des Betriebes des realen Halbleitermoduls entsprechen, wobei z.B. eine Umgebungstemperatur und eine Schaltfrequenz zu den einstellbaren Betriebsbedingungen gehören. Unter Berücksichtigung der Umgebungstemperatur und der Schaltfrequenz kann in diesem Fall ein Schaltverhalten ausgegeben werden.

Eine weitere Ausführungsform sieht vor, dass der Kontaktierungsabschnitt und der Verbindungsabschnitt jeweils um +/-90° zum jeweiligen Mittelabschnitt gebogen sind. Auf diese Weise wird die Fläche, welche durch das Biegen mittels der vier Kontaktflächen eingeschlossen wird, optimiert.

Eine weitere Ausführungsform sieht vor, dass der Kontaktierungsabschnitt und/oder der Verbindungsabschnitt zweier benachbarter Kontaktelektroden in unterschiedliche Richtungen gebogen sind. Auf diese Weise lässt sich flexibel unter anderem ein besonders großer oder ein besonders geringer Abstand zwischen den Kontaktelektroden, insbesondere in einem Standardgehäuse, realisieren, sodass eine verbesserte Wärmespreizung und/oder eine Erhöhung der Schaltfrequenz erreichbar ist.

Eine weitere Ausführungsform sieht vor, dass Mittelabschnitte der Kontaktelektroden jeweils zumindest teilweise senkrecht zur Oberfläche verlaufend angeordnet sind, wobei eine, insbesondere rechteckige, Querschnittsfläche des jeweiligen Mittelabschnitts einen Mittelpunkt aufweist, wobei die Mittelpunkte der Kontaktelektroden in einem Raster angeordnet sind. Insbesondere sind der Kontaktierungsabschnitt und der Verbindungsabschnitt im Wesentlichen parallel zur Oberfläche verlaufend angeordnet. Unter einem Raster ist in diesem Zusammenhang eine Anordnung von regelmäßig in einer Ebene verteilten Punkten zu verstehen, wobei die Ebene insbesondere parallel zur Oberfläche verläuft. Beispielsweise sind die Mittelpunkte in einem kartesischen Raster angeordnet, sodass die Abstände zwischen den Mittelpunkten zumindest in eine Richtung einheitlich lang sind. Eine derartige Anordnung ermöglicht unter anderem die Verwendung eines standardisierten Gehäuses. Durch eine Rasterung ist das Modul einfach und kostengünstig skalierbar.

Eine weitere Ausführungsform sieht vor, dass das Halbleitermodul sechs Kontaktelektroden aufweist, wobei deren Mittelpunkte in einem 3x2-Raster angeordnet sind. Bei einer derartigen Rasterung ergeben sich drei Paare von Kontaktelektroden. Durch paarweises Kurzschließen sind verschiedene Schaltungstopologien realisierbar, wobei das Layout durch die flexiblen Kontaktelektroden an die jeweilige Schaltungstopologie anpassbar ist. Somit sind verschiedene Schaltungstopologien im selben Gehäuse realisierbar.

Eine weitere Ausführungsform sieht vor, dass die jeweils vier, insbesondere rechteckförmig angeordneten, Kontaktflächen der sechs Kontaktelektroden auf dem Substrat eine Fläche einschließen, welche mindestens 20 %, insbesondere 30 % einer stromführenden Substratfläche beträgt. Unter einer stromführenden Substratfläche ist in diesem Zusammenhang die Substratfläche zumindest eines Substrates zu verstehen, welche dafür vorgesehen, insbesondere konfiguriert, ist, dass während eines Betriebes des Halbleitermoduls ein Laststrom fließt. Somit kann ein Substrat mit einer stromführenden Substratfläche auch als laststromführendes Substrat bezeichnet werden. Durch eine derartig große eingeschlossene Fläche ist eine sehr große Flexibilität bei der Kontaktierung der Kontaktelektroden erreichbar.

Eine weitere Ausführungsform sieht vor, dass die Kontaktflächen ungleichmäßig auf einer stromführenden Substratfläche verteilt sind. Durch eine ungleichmäßige Verteilung kann, unter anderem, eine verbesserte Wärmespreizung erreicht werden.

Eine weitere Ausführungsform sieht vor, dass die Kontaktflächen symmetrisch zu einer Längsmittelachse einer stromführenden Substratfläche angeordnet sind. Die Längsmittelachse teilt die stromführende Substratfläche mittig in Längsrichtung. Eine derartige Symmetrie im Layout ermöglicht eine gleichmäßige Stromverteilung zwischen den Halbleiterelementen, sodass hohe Schaltfrequenzen, insbesondere > 5 kHz, erreicht werden können.

Eine weitere Ausführungsform sieht vor, dass die Halbleiterschaltung zumindest ein, insbesondere rechteckiges, Steuersubstrat, welches auf der ebenen Oberfläche der Wärmesenke angeordnet ist, aufweist, wobei das zumindest eine Steuersubstrat über Verdrahtungselemente mit dem zumindest einen Substrat verbunden ist, wobei eine Fläche des Steuersubstrats maximal 15 %, insbesondere maximal 10 %, der Fläche des zumindest einen Substrats beträgt. Ein rechteckiges Steuersubstrat weist eine rechteckige Substratfläche auf. Durch ein derartiges separates Steuersubstrat wird eine Fläche des laststromführenden Substrats reduziert, was sich positiv auf die Kosten auswirkt. Ferner wird durch das zumindest eine separate Steuersubstrat, insbesondere bei einer Modulparallelschaltung, ein Kreuzen von Signalen auf einer Treiberschaltung vermieden. Überdies wird ein kompakteres Layout ermöglicht.

Eine weitere Ausführungsform sieht vor, dass das Steuersubstrat zwischen zwei Befestigungslöchern der Wärmesenke angeordnet ist. Durch eine derartige Anordnung wird die Oberfläche der Wärmesenke optimal ausgenutzt ohne dass teure abgeschrägte Ecken des Schaltungsträgers erforderlich sind.

Eine weitere Ausführungsform sieht vor, dass die Halbleiterschaltung Shunt-Widerstände aufweist, welche auf dem Substrat kontaktiert sind, wobei die Halbleiterelemente und die Shunt-Widerstände symmetrisch zu einer Längsmittelachse einer stromführenden Substratfläche angeordnet sind. Eine derartige Symmetrie im Layout ermöglicht eine gleichmäßige Stromverteilung zwischen den Halbleiterelementen, sodass hohe Schaltfrequenzen, insbesondere > 5 kHz, erreicht werden können.

Eine weitere Ausführungsform sieht vor, dass die Halbleiterelemente symmetrisch um zumindest eine Kontaktfläche einer Kontaktelektrode auf dem Substrat angeordnet sind. Beispielsweise sind jeweils vier Halbleiterelemente im Wesentlichen punktsymmetrisch um eine Kontaktfläche einer Kontaktelektrode angeordnet. Durch eine derartige Anordnung werden lange Stromführende Leiterzüge auf dem Substrat vermieden. Somit werden insbesondere Zuleitungsinduktivitäten reduziert, was sich positiv auf das Schaltverhalten auswirkt.

Eine weitere Ausführungsform sieht vor, dass die Halbleiterelemente Transistoren und Dioden umfassen, wobei die Dioden, bezogen auf eine Längsmittelachse, zwischen den Transistoren angeordnet sind. Da die Transistoren während des Betriebes signifikant mehr Verlustleistung erzeugen, wird eine Anordnung von dicht beieinanderliegenden Bauelementen mit hohen Verlustleistungen vermieden. Somit wird eine bestmögliche Ausnutzung einer Temperaturspreizung über die Wärmesenke erreicht.

Eine weitere Ausführungsform sieht vor, dass das Herstellen der Kontaktelektroden folgende Schritte umfasst: Ausrichten des unsymmetrischen metallisches Biegeteils bezüglich der Längsachse anhand des L-förmigen Verbindungsabschnitts, erstes Biegen des Kontaktierungsabschnitts zum Mittelabschnitt um eine erste Biegeachse, zweites Biegen des L-förmigen Verbindungsabschnitts um eine zweite Biegeachse. Durch ein derartiges Herstellungsverfahren sind die Kontaktelektroden, insbesondere aus im Wesentlichen identisch ausgeführten, Biegeteilen mittels eines gemeinsamen Stanzwerkzeugs herstellbar, was Zeit und Kosten einspart.

Im Folgenden wird die Erfindung anhand der in den Figuren dargestellten Ausführungsbeispiele näher beschrieben und erläutert.

Es zeigen:
- FIG 1: eine schematische dreidimensionale Darstellung einer ersten Ausführungsform eines Halbleitermoduls in einer Außenansicht,
- FIG 2: eine schematische dreidimensionale Darstellung der ersten Ausführungsform des Halbleitermoduls in einer Innenansicht,
- FIG 3: eine dreidimensionale Darstellung einer Kontaktelektrode,
- FIG 4: eine schematische Darstellung von Kontaktelektroden auf einem Substrat in einer Draufsicht,
- FIG 5: eine schematische Darstellung einer zweiten Ausführungsform eines Halbleitermoduls in einer Draufsicht,
- FIG 6: eine schematische Darstellung der ersten Ausführungsform des Halbleitermoduls in einer Draufsicht,
- FIG 7: eine schematische Darstellung einer dritten Ausführungsform eines Halbleitermoduls in einer Draufsicht,
- FIG 8: eine schematische Darstellung einer vierten Ausführungsform eines Halbleitermoduls in einer Draufsicht,
- FIG 9: eine schematische Darstellung eines Stromrichters und
- FIG 10: ein Verfahren zur Herstellung einer Kontaktelektrode.

Bei den im Folgenden erläuterten Ausführungsbeispielen handelt es sich um bevorzugte Ausführungsformen der Erfindung.

Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

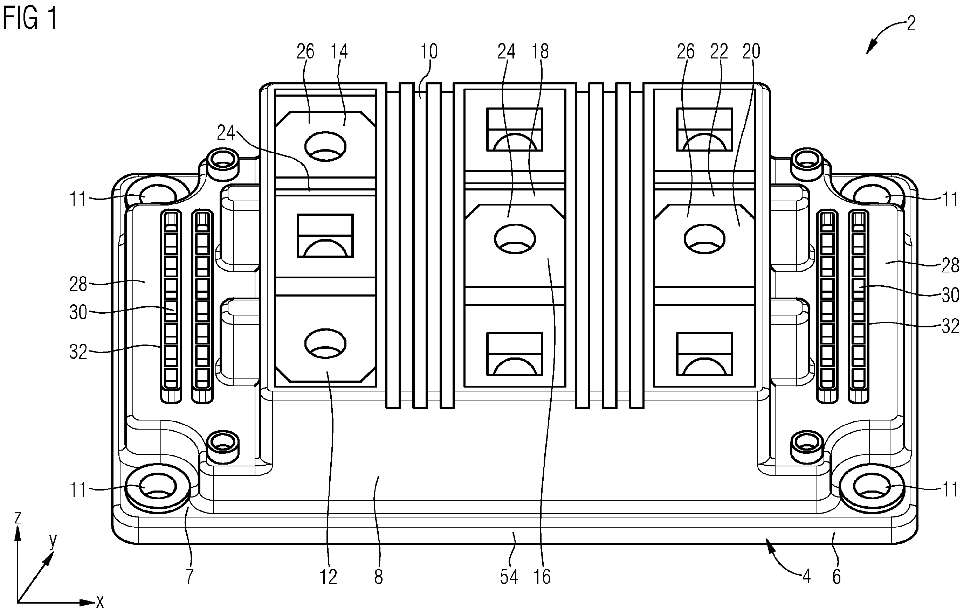

FIG 1 zeigt eine schematische dreidimensionale Darstellung einer ersten Ausführungsform eines Halbleitermoduls 2 in einer Außenansicht, welches ein geschlossenes Gehäuse 4 mit einer Wärmesenke 6 umfasst, wobei die Wärmesenke 6 als eine metallische Grundplatte bzw. Bodenplatte ausgeführt ist. Die metallische Bodenplatte weist eine ebene Oberfläche 7 auf, welche eine xy-Ebene definiert. Ferner umfasst das Gehäuse 4 Seitenflächen 8, welche mit der Oberfläche 7 der metallischen Bodenplatte verbunden sind, und eine Deckfläche 10. Seiten- und Deckfläche 8, 10 sind beispielsweise aus einem Kunststoff hergestellt. Darüber hinaus weist die Wärmesenke 6 vier im Bereich der abgerundeten Ecken der rechteckigen Oberfläche 7 angeordnete Befestigungslöcher 11 auf.

Das Halbleitermodul 2 weist beispielhaft sechs Kontaktelektroden 12, 14, 16, 18, 20, 22 auf, die mit einer in FIG 1 aufgrund des Gehäuses 4 nicht sichtbar dargestellten Halbleiterschaltung verbunden und jeweils durch eine Gehäuseausnehmung 24 in der Deckfläche 10 des Gehäuses 4 nach außen geführt sind. Die Gehäuseausnehmung 24 ist beispielsweise als eine länglich ausgedehnte, insbesondere rechteckförmige, Öffnung in der Deckfläche 10 des Gehäuses 4 ausgeführt. Die Kontaktelektroden 12, 14, 16, 18, 20, 22 sind als metallische Stanz- und Biegeteile ausgeführt und weisen jeweils einen Kontaktierungsabschnitt 26 auf, über welchen die jeweilige Kontaktelektrode 12, 14, 16, 18, 20, 22 mittels einer Schraube, beispielsweise mit einer Stromschiene, verbindbar ist. Die Kontaktierungsabschnitte 26 der ersten und zweiten Kontaktelektrode 12, 14 sind jeweils um 90° voneinander weg gebogen und somit einzeln verbindbar, während die Kontaktierungsabschnitte 26 der dritten und vierten Kontaktelektrode 16, 18 sowie der fünften und sechsten Kontaktelektrode 20, 22 jeweils um 90° aufeinander zu gebogen sind und sich paarweise flächig überlappen, sodass diese paarweise kurzgeschlossen und gemeinsam verbindbar sind.

Das Gehäuse 4 weist darüber hinaus beidseitig zur Deckfläche 10 angeordnete seitliche Deckflächen 28 auf, welche stufenförmig versetzt zur Deckfläche 10 des Gehäuses 4 angeordnet sind. Steuerpins 30, welche mit der Halbleiterschaltung verbunden sind, sind durch, insbesondere rechteckförmige, seitliche Gehäuseausnehmungen 32 in den seitlichen Deckflächen 28 nach außen geführt.

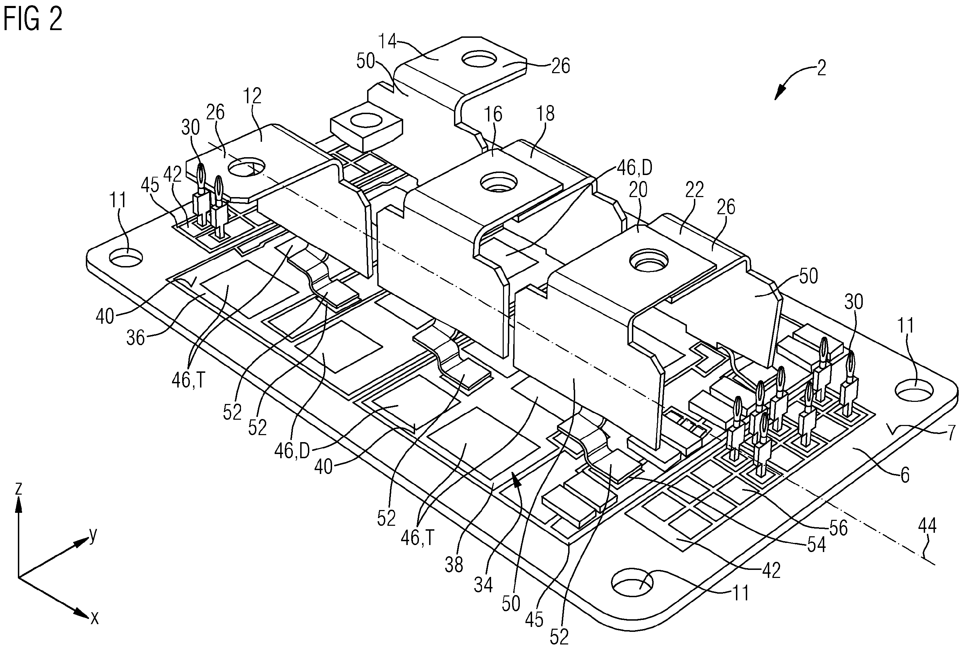

FIG 2 zeigt eine schematische dreidimensionale Darstellung der ersten Ausführungsform des Halbleitermoduls 2 in einer Innenansicht, wobei die Seiten- und Deckflächen 8, 10, 28 des Gehäuses 4 aus Gründen der Übersichtlichkeit nicht dargestellt sind. Das Halbleitermodul 2 weist eine Halbleiterschaltung 34 auf, welche zwei Substrate 36, 38 mit jeweils einer rechteckförmigen stromführenden Substratfläche 40 umfasst. Unter einer stromführenden Substratfläche 40 ist in diesem Zusammenhang die Substratfläche zumindest eines Substrates 36, 38 zu verstehen, welche dafür vorgesehen ist, dass während eines Betriebes des Halbleitermoduls 2 ein Laststrom fließt. Ein Substrat mit einer stromführenden Substratfläche wird auch als oder laststromführende bezeichnet.

Ferner weist die Halbleiterschaltung 34 zwei beidseitig zu den Substraten 36, 38 angeordnete rechteckige Steuersubstrate 42 auf. Die Substrate 36, 38 und Steuersubstrate 42 sind in x-Richtung hintereinander und achsensymmetrisch bezüglich einer Längsmittelachse 44 auf der Oberfläche 7 der Wärmesenke 6 angeordnet. Insbesondere sind die Substrate 36, 38 und Steuersubstrate 42 stoffschlüssig, beispielsweise durch eine Löt- oder Sinterverbindung, auf der Oberfläche 7 der Wärmesenke 6 verbunden. Die rechteckigen Steuersubstrate 42 sind jeweils zwischen zwei Befestigungslöchern 11 der Wärmesenke 6 angeordnet. Die Substraten 36, 38 und Steuersubstrate 42 weisen eine dielektrische Materiallage 45, die beispielsweise einen keramischen Werkstoff, insbesondere Aluminiumnitrid oder Aluminiumoxid, enthält auf. Die dielektrische Materiallage 45 weist eine Stärke von 25 µm bis 400 µm, insbesondere 50 µm bis 250 µm, auf. Die Substrate 36, 38 und Steuersubstrate 42 können unter anderem als DCB Substrate ausgeführt sein.

Auf den stromführenden Substraten 36, 38 sind Halbleiterelemente 46 stoffschlüssig, beispielsweise durch eine Löt- oder Sinterverbindung, verbunden, wobei die Halbleiterelemente 46 als Transistoren T oder als Dioden D ausgeführt sind. Die Transistoren T sind beispielsweise als IGBTs oder als Wide-Bandgap-Transistoren ausgeführt. Die Dioden können beispielsweise jeweils antiparallel zu zumindest einem Transistor T geschaltet sein. Die Transistoren T und Dioden sind jeweils in in y-Richtung verlaufenden Reihen angeordnet, wobei die Reihen der Dioden D, bezogen auf die Längsmittelachse 44, zwischen den Transistoren T angeordnet sind, sodass durch den daraus resultierenden größeren Abstand der Reihen der Transistoren T, welche eine vergleichsweise hohe Verlustleistung aufweisen, zueinander eine bestmögliche Temperaturspreizung über die Wärmesenke 6 erreicht wird. Insbesondere sind die in einer Reihe angeordneten Transistoren T und antiparallelen Dioden D des jeweiligen Substrats 36, 38 parallelgeschaltet. Die Halbleiterschaltung 34 weist darüber hinaus Shunt-Widerstände 48 auf, welche auf dem zweiten Substrat 38 kontaktiert sind. Die Halbleiterelemente 46 und die Shunt-Widerstände 48 sind symmetrisch zur Längsmittelachse 44 auf den Substraten 36, 38 angeordnet.

Die Kontaktelektrode 12, 14, 16, 18, 20, 22 weisen neben dem Kontaktierungsabschnitt 26 einen Mittelabschnitt 50 und einen mit dem jeweiligen Substrat 36, 38 verbindbaren Verbindungsabschnitt 52 auf, wobei der Kontaktierungsabschnitt 26 und der Verbindungsabschnitt 52 jeweils um +/- 90° zum jeweiligen Mittelabschnitt 50 gebogen sind. Die Verbindungsabschnitte 52 der Kontaktelektroden 12, 14, 16, 18, 20, 22 sind jeweils mit einer Kontaktfläche 54 auf dem jeweiligen Substrat 36, 38 verbunden. Die Kontaktflächen 54 sind symmetrisch zur Längsmittelachse 44 auf den Substraten 36, 38 angeordnet. Insbesondere sind jeweils vier Halbleiterelemente 46 symmetrisch um eine Kontaktflächen 54 angeordnet, um eine gleichmäßige Stromverteilung zu erreichen und damit kürzere Schaltzeiten zu ermöglichen. Die Halbleiterelemente 46 weisen jeweils einen direkten Strompfad zu einer Kontaktfläche 54 auf. Ein direkter Strompfad bedeutet, dass sich kein weiteres Halbleiterelement oder passives diskretes Bauelement, z.B. ein Shunt-Widerstand, zwischen dem jeweiligen Halbleiterelement 46 und der Kontaktfläche 54 befindet. Durch einen derartigen direkten Strompfad wird eine gleichmäßige Stromverteilung und eine Reduzierung von Zuleitungsimpedanzen erreicht, was sich ebenfalls positiv auf das Schaltverhalten auswirkt.

Die Steuersubstrate 42 weisen eine Metallisierung mit rechteckigen, insbesondere quadratischen, Feldern 56 auf, die gleichmäßig in einem Raster auf dem jeweiligen Steuersubstrat 42 angeordnet sind. Die Steuerpins 30 sind als freistehende Pins, welche stoffschlüssig, beispielsweise durch eine Löt- oder Sinterverbindung, auf einem der Felder 56 verbunden sind, ausgeführt.

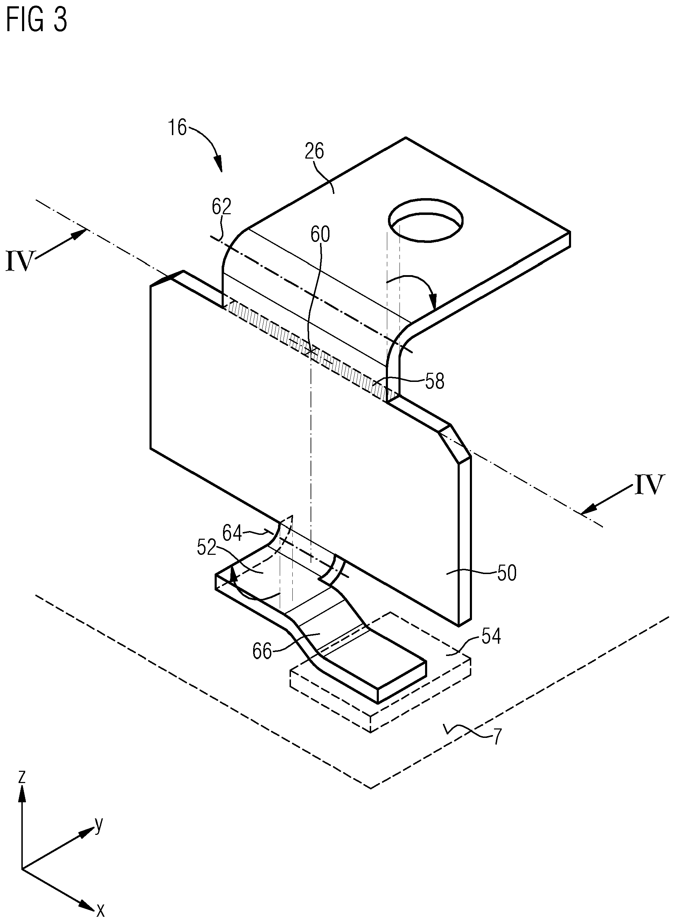

FIG 3 zeigt eine dreidimensionale Darstellung einer Kontaktelektrode 16, welche einen Kontaktierungsabschnitt 26, einen Mittelabschnitt 50 und einen mit einer Kontaktfläche 54 verbindbaren Verbindungsabschnitt 52 aufweist. Der Mittelabschnitt 50 der Kontaktelektroden 16 ist senkrecht zur Oberfläche 7 verlaufend angeordnet. Eine rechteckige Querschnittsfläche 58 des Mittelabschnitts 50 ist parallel zur Oberfläche 7 verlaufend angeordnet und weist einen Mittelpunkt 60 auf. Durch translatorisches Biegen des Kontaktierungsabschnitts 26 zum Mittelabschnitt 50 um einen ersten Winkel α wird eine erste Biegung 62 ausgebildet, während durch translatorisches bzw. lineares Biegen des Verbindungsabschnitts 52 zum Mittelabschnitt 50 um einen zweiten Winkel β eine zweite Biegung 64 ausgebildet wird. Beispielhaft sind der Kontaktierungsabschnitt 26 und der Verbindungsabschnitt 52 rechtwinkelig zu gegenüberliegenden Seiten des Mittelabschnitts 50 gebogen, sodass der Kontaktierungsabschnitt 26 und der Verbindungsabschnitt 52 jeweils im Wesentlichen parallel zur Oberfläche verlaufen. Zusätzlich weist der Verbindungsabschnitt 52 eine S-förmige Biegung 66 auf, wodurch der Verbindungsabschnitt 52 eine erhöhe Elastizität aufweist. Die erhöhte Elastizität führt zu einer mechanischen Entlastung der Verbindung des Verbindungsabschnitts 52 mit der jeweiligen Kontaktfläche 54. Die weitere Ausführung der Kontaktelektrode 16 in FIG 3 entspricht der in FIG 1 bzw. FIG 2.

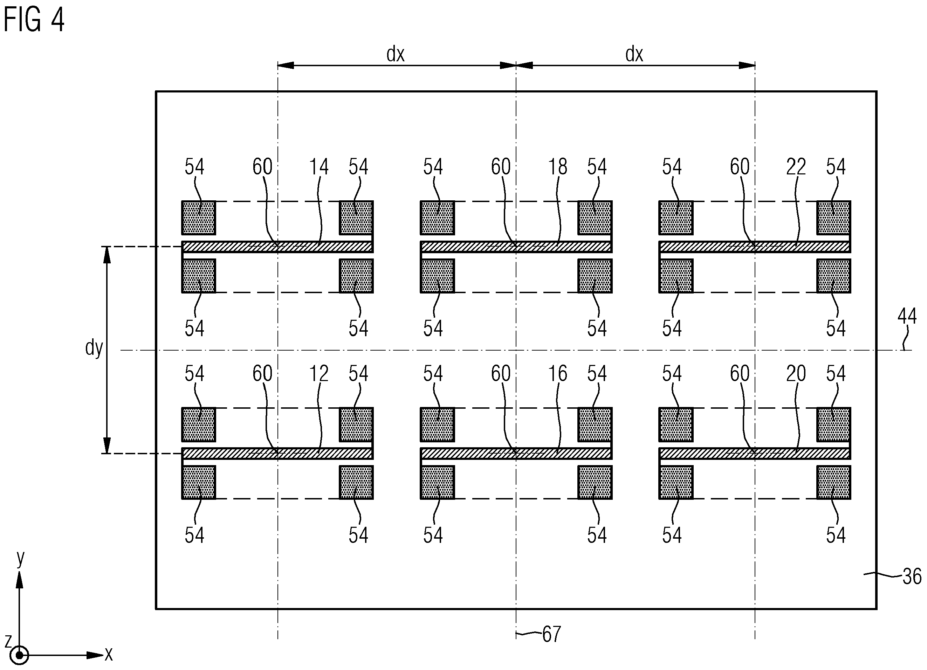

FIG 4 zeigt eine schematische Darstellung von Kontaktelektroden 12, 14, 16, 18, 20, 22 auf einem Substrat in einer Draufsicht, welche wie in FIG 3 ausgeführt und in einem in einem 3x2-Raster angeordnet sind. Die Kontaktelektroden 12, 14, 16, 18, 20, 22 sind bezogen auf ihre Mittelpunkte 60 symmetrisch zur Längsmittelachse 44 und zu einer Querachse 67 angeordnet, sodass die Abstände dx, dy in x-Richtung und y-Richtung zwischen den Mittelpunkten 60 der Kontaktelektroden 12, 14, 16, 18, 20, 22 gleich groß sind. Durch das, insbesondere translatorische, Biegen der Kontaktierungsabschnitte 26 und Verbindungsabschnitte 52 zum jeweiligen Mittelabschnitt 50 bei fixer Positionierung der jeweiligen Mittelpunkte 60 sind pro Kontaktelektrode 12, 14, 16, 18, 20, 22 vier rechteckförmig angeordnete Kontaktflächen 54 auf dem Substrat 36 verbindbar. Die vier rechteckförmig angeordnete Kontaktflächen 54 der sechs Kontaktelektroden 12, 14, 16, 18, 20, 22 schließen auf dem Substrat 36 eine Fläche ein, welche mindestens 20 %, insbesondere 30 % ^der stromführenden Substratfläche 40 beträgt.

Durch das Biegen des Kontaktierungsabschnitts 26 zum Mittelabschnitt 50 wird neben dem Kontaktierungsabschnitt 26 zusätzlich der L-förmige Verbindungsabschnitt 52 ausgerichtet. Somit können die Kontaktelektroden 12, 14, 16, 18, 20, 22 aus einem metallischen Biegeteil mittels eines gemeinsamen Werkzeugs hergestellt werden. Die weitere Ausführung der Anordnung in FIG 3 entspricht der in FIG 1 bzw. FIG 2.

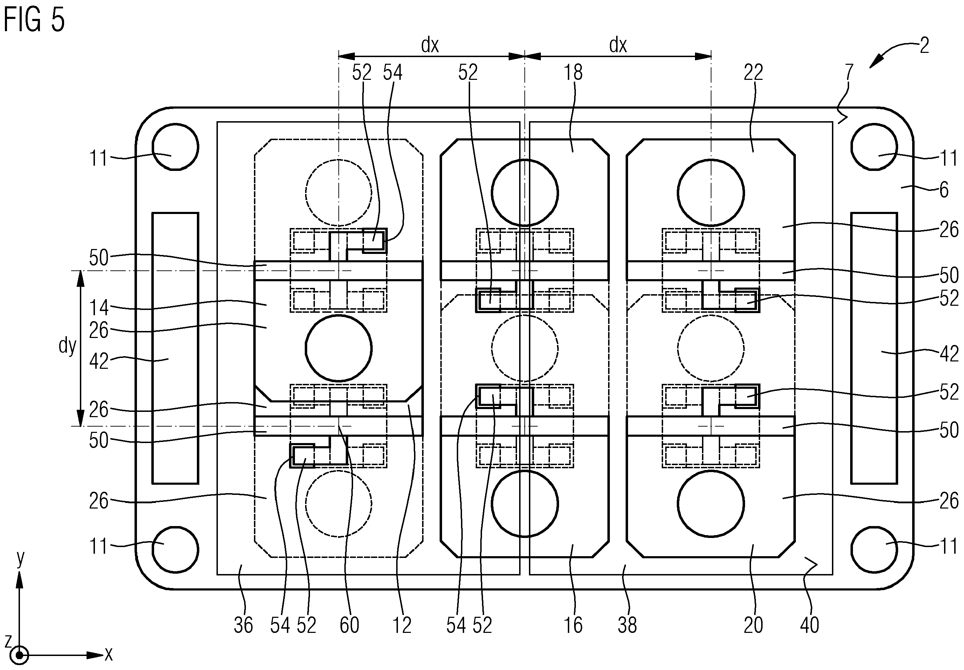

FIG 5 zeigt eine schematische Darstellung einer zweiten Ausführungsform eines Halbleitermoduls 2 in einer Draufsicht, wobei die sechs Kontaktelektroden 12, 14, 16, 18, 20, 22, wie in FIG 4 gezeigt, in einem 3x2-Raster angeordnet sind. Die Kontaktierungsabschnitte 26 der ersten und zweiten Kontaktelektrode 12, 14 sind jeweils um 90° aufeinander zu gebogen und überlappen sich flächig, sodass diese kurzgeschlossen und gemeinsam verbindbar sind, während die dritte und vierte Kontaktelektrode 16, 18 sowie die fünfte und sechste Kontaktelektrode 20, 22 jeweils paarweise um 90° voneinander weg gebogen und somit einzeln verbindbar sind. Beispielsweise sind der Kontaktierungsabschnitt 26 und der Verbindungsabschnitt 52 der benachbarten ersten und dritten Kontaktelektrode 12, 16 in unterschiedliche Richtungen gebogen. Die Kontaktflächen 54 sind ungleichmäßig auf einer stromführenden Substratfläche 40 der Substrate 36, 38 verteilt. Wie in FIG 4 gezeigt, schließen die vier rechteckförmig angeordnete Kontaktflächen 54 der sechs Kontaktelektroden 12, 14, 16, 18, 20, 22 auf den Substraten 36, 38 eine Fläche ein, welche mindestens 20 %, insbesondere 30 % der stromführenden Substratfläche 40 der Substraten36, 38 beträgt. Die weitere Ausführung der Anordnung in FIG 5 entspricht der in FIG 1 bzw. FIG 2.

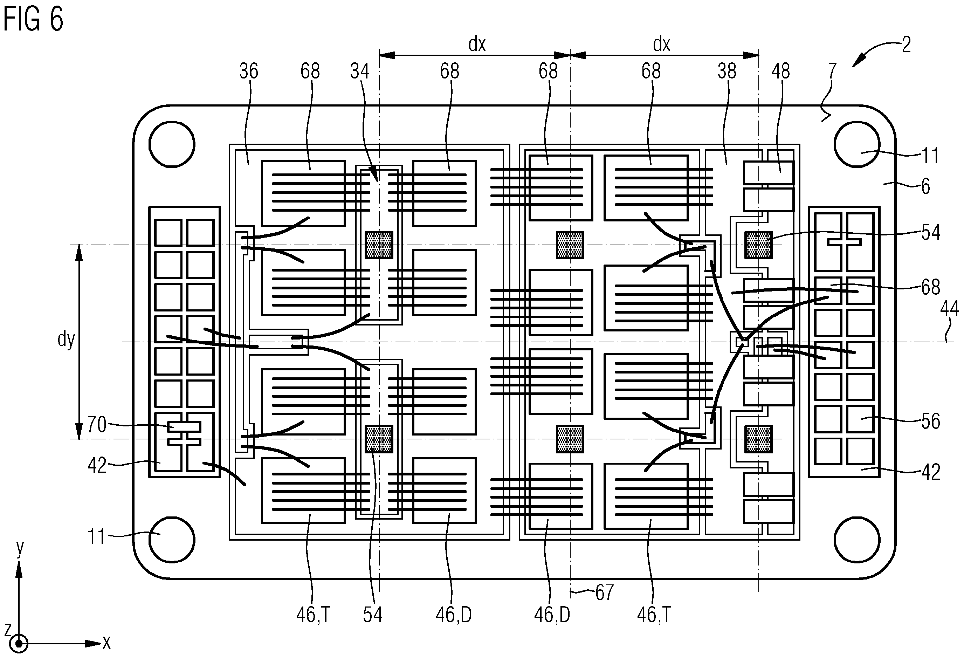

FIG 6 zeigt eine schematische Darstellung der ersten Ausführungsform des Halbleitermoduls 2 in einer Draufsicht, wobei die Seiten- und Deckflächen 8, 10, 28 des Gehäuses 4 sowie die Kontaktelektroden 12, 14, 16, 18, 20, 22 und Steuerpins 30 aus Gründen der Übersichtlichkeit nicht dargestellt sind. Die Steuersubstrate 42 sind über Verdrahtungselemente 68 mit dem jeweiligen Substrat 36, 38 verbunden. Die Kontaktflächen 54 sind, genau wie die Kontaktelektroden 12, 14, 16, 18, 20, 22, in einem 3x2 Raster symmetrisch zur Längsmittelachse 44 und zur Querachse 67 angeordnet, sodass auch die Abstände dx, dy in x-Richtung und y-Richtung zwischen den Kontaktflächen 54 gleich groß sind. Die Verbindungsabschnitte 52 der jeweiligen in x-Richtung benachbart angeordneten Kontaktelektroden 12, 16, 20; 14, 18, 22 sind, wie in FIG 2 gezeigt, in dieselbe Richtung gebogen. Die Halbleiterelemente 46 sind über parallele im Wesentlichen in x-Richtung verlaufende Verdrahtungselemente 68 mit den Kontaktflächen 54 verbunden. Ein Sensor 70, insbesondere ein Temperatursensor, der beispielsweise als NTC-Thermistor (Negative Temperature Coefficient Thermistor) ausgeführt ist, ist auf einem Steuersubstrat 42 angeordnet. Die Halbleiterschaltung 34 ist beispielsweise als eine Halbbrücke ausbildet. Die weitere Ausführung der Anordnung in FIG 6 entspricht der in FIG 1 bzw. FIG 2.

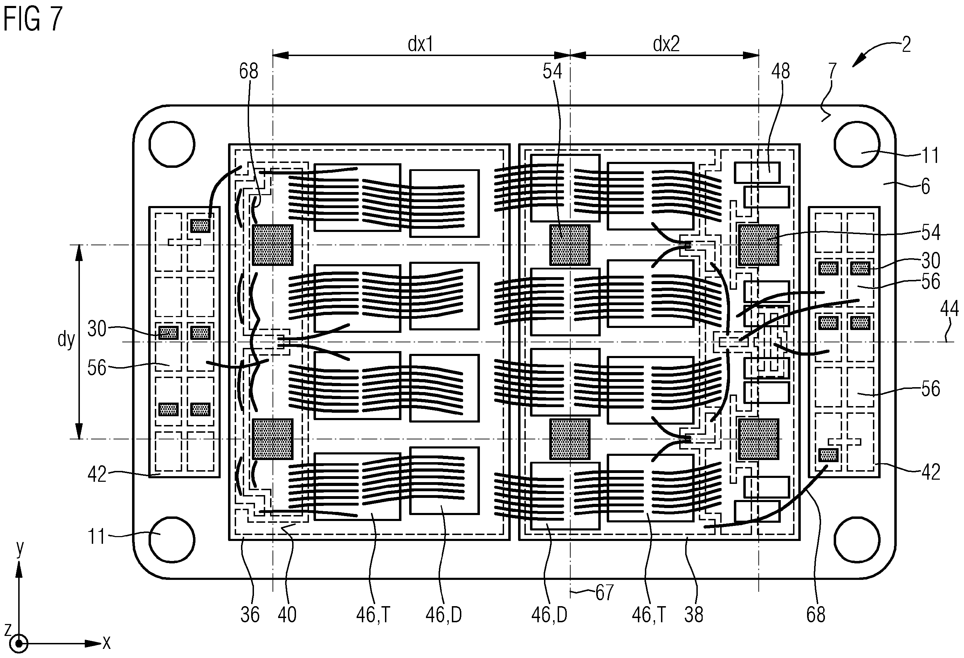

FIG 7 zeigt eine schematische Darstellung einer dritten Ausführungsform eines Halbleitermoduls in einer Draufsicht, wobei die Seiten- und Deckflächen 8, 10, 28 des Gehäuses 4 sowie die Kontaktelektroden 12, 14, 16, 18, 20, 22 aus Gründen der Übersichtlichkeit nicht dargestellt sind. Die Kontaktflächen 54 sind symmetrisch zur Längsmittelachse 44 angeordnet, wobei keine Symmetrie zur Querachse 67 vorliegt und somit die Abstände dx1, dx2 in x-Richtung unterschiedlich groß sind. Die Verbindungsabschnitte 52 zweiter in x-Richtung benachbart angeordneter Kontaktelektroden 12, 16, 20; 14, 18, 22 sind in unterschiedliche Richtungen gebogen, sodass sich unterschiedliche Abstände dx1, dx2 in x-Richtung ergeben, während die nicht in FIG 7 dargestellten Kontaktelektroden 12, 14, 16, 18, 20, 22, in einem 3x2 Raster symmetrisch zur Längsmittelachse 44 und zur Querachse 67 angeordnet sind. Die weitere Ausführung der Anordnung in FIG 7 entspricht der in FIG 6.

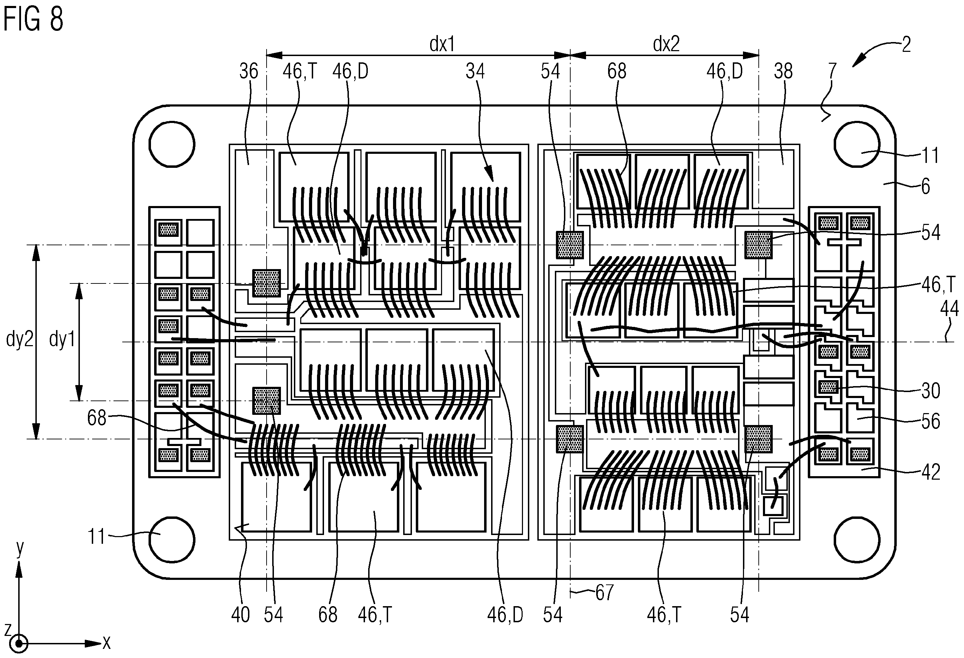

FIG 8 zeigt eine schematische Darstellung einer vierten Ausführungsform eines Halbleitermoduls 2 in einer Draufsicht, wobei die Seiten- und Deckflächen 8, 10, 28 des Gehäuses 4 sowie die Kontaktelektroden 12, 14, 16, 18, 20, 22 aus Gründen der Übersichtlichkeit nicht dargestellt sind. Es liegt keine Symmetrie der Kontaktflächen 54 zur Längsmittelachse 44 oder Querachse 67 vor. Die Abstände dx1, dx2 in x-Richtung sowie die Abstände dy1, dy2 in y-Richtung sind jeweils unterschiedlich groß, während die nicht in FIG 8 dargestellten Kontaktelektroden 12, 14, 16, 18, 20, 22, in einem 3x2 Raster symmetrisch zur Längsmittelachse 44 und zur Querachse 67 angeordnet sind. Die Halbleiterschaltung 34 ist beispielsweise als ein t-type NPC ausbildet, wobei das Layout in vier Quadranten eingeteilt ist. Die Halbleiterelemente 46 auf dem ersten Substrat 36 sind größer als die Halbleiterelemente 46 auf dem zweiten Substrat 38 ausgeführt. Ferner sind die Transistoren T auf dem ersten Substrat 36 maximal beabstandet, um eine bestmögliche Temperaturspreizung über die Wärmesenke 6 zu erreichen. Die weitere Ausführung der Anordnung in FIG 8 entspricht der in FIG 7.

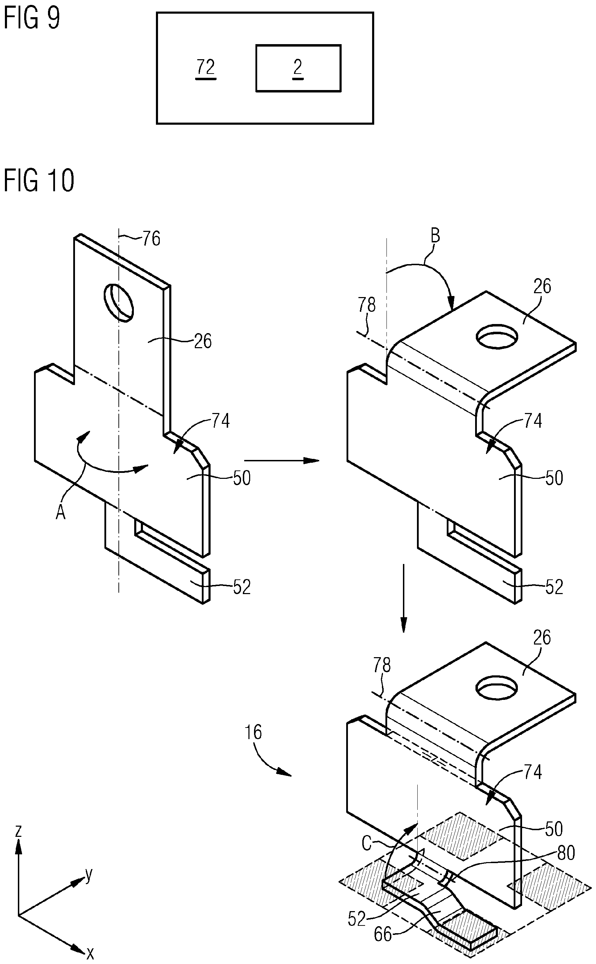

FIG 9 zeigt eine schematische Darstellung eines Stromrichters 72, welcher beispielhaft ein Halbleitermodul 2 umfasst.

FIG 10 zeigt ein Verfahren zur Herstellung einer Kontaktelektrode 16, wobei zunächst ein durch Stanzen herstellbares metallisches Biegeteils 74 bereitgestellt wird, welches aufgrund eines L-förmigen Verbindungsabschnitts 52 unsymmetrisch bezüglich einer durch eine Längsachse 76 parallel zur yz-Ebene verlaufende Ebene ausgeführt ist. Das metallische Biegeteil 74 ist beispielsweise als ebenes Metallblech und somit im Wesentlichen symmetrisch bezüglich einer parallel zur xz-Ebene verlaufenden Ebene ausgeführt. Alle metallischen Biegeteile 74 zur Herstellung der Kontaktelektroden 12, 16, 20, 14, 18, 22 eines Halbleitermoduls 2 können mit einem gemeinsamen Stanzwerkzeug hergestellt werden. Insbesondere sind alle metallischen Biegeteile 74 zur Herstellung der Kontaktelektroden 12, 16, 20, 14, 18, 22 eines Halbleitermoduls 2 identisch ausgeführt.

Es erfolgt ein Ausrichten A des unsymmetrischen metallischen Biegeteils 74 bezüglich der Längsachse 76, sodass der L-förmige Verbindungsabschnitt 52 in +x- oder alternativ in - x-Richtung ausgerichtet ist.

In einem weiteren Schritt erfolgt ein, insbesondere translatorisches, erstes Biegen B des Kontaktierungsabschnitts 26 zum Mittelabschnitt 50 um eine erste Biegeachse 78. Beispielsweise erfolgt das erste Biegen B um +90° in +y-Richtung. Alternativ kann das erste Biegen B, z.B. um - 90°, in -y-Richtung erfolgen.

In einem weiteren Schritt erfolgt ein, insbesondere translatorisches, zweites Biegen C des L-förmigen Verbindungsabschnitts 52 um eine zweite Biegeachse 80. Beispielsweise erfolgt das zweite Biegen C um -90° in -y-Richtung. Alternativ kann das zweite Biegen C, z.B. um +90°, in +y-Richtung erfolgen. Ferner wird eine S-förmige Biegung 66 im Verbindungsabschnitt 52 hergestellt.

Zusammenfassend betrifft die Erfindung ein Halbleitermodul 2 aufweisend eine Halbleiterschaltung 34 und ein Gehäuse 4, welches eine Wärmesenke 6 umfasst, wobei das Gehäuse 4, die Halbleiterschaltung 34 zumindest teilweise umgibt, wobei die Halbleiterschaltung 34 zumindest ein Substrat 36, 38, welches auf einer ebenen Oberfläche 7 der Wärmesenke 6 angeordnet ist, Halbleiterelemente 46, welche auf dem zumindest einen Substrat 36, 38 kontaktiert sind, aufweist. Um ein möglichst flexibles Halbleitermodul 2 anzugeben, das hohe Schaltfrequenzen und Leistungsdichten ermöglicht, wird vorgeschlagen, dass Kontaktelektroden 12, 16, 20, 14, 18, 22 mit der Halbleiterschaltung 34 verbunden und jeweils durch eine Gehäuseausnehmung 24 in einer Deckfläche 10 des Gehäuses 4 nach außen geführt sind, wobei die Kontaktelektroden 12, 16, 20, 14, 18, 22 jeweils einen zumindest teilweise nach außen geführten Kontaktierungsabschnitt 26, einen Mittelabschnitt 50 und einen mit dem Substrat 36, 38 verbindbaren Verbindungsabschnitt 52 aufweisen, wobei der Verbindungsabschnitt 52 der jeweiligen Kontaktelektrode 12, 16, 20, 14, 18, 22 durch, insbesondere translatorisches, Biegen des Kontaktierungsabschnitts 26 und Verbindungsabschnitts 52 zum jeweiligen Mittelabschnitt 50 bei fixer Positionierung zur Gehäuseausnehmung 24 mit vier, insbesondere rechteckförmig angeordneten, Kontaktflächen 54 auf dem Substrat 36, 38 verbindbar ist.

## Patentansprüche

1. Halbleitermodul (2) aufweisend eine Halbleiterschaltung (34) und ein Gehäuse (4), welches eine Wärmesenke (6) umfasst,
wobei das Gehäuse (4), die Halbleiterschaltung (34) zumindest teilweise umgibt,
wobei die Halbleiterschaltung (34) zumindest ein Substrat (36, 38), welches auf einer ebenen Oberfläche (7) der Wärmesenke (6) angeordnet ist, Halbleiterelemente (46), welche auf dem zumindest einen Substrat (36, 38) kontaktiert sind, aufweist,
wobei Kontaktelektroden (12, 16, 20, 14, 18, 22) mit der Halbleiterschaltung (34) verbunden und jeweils durch eine Gehäuseausnehmung (24) in einer Deckfläche (10) des Gehäuses (4) nach außen geführt sind,
wobei die Kontaktelektroden (12, 16, 20, 14, 18, 22) jeweils einen zumindest teilweise nach außen geführten Kontaktierungsabschnitt (26), einen Mittelabschnitt (50) und einen mit dem Substrat (36, 38) verbindbaren Verbindungsabschnitt (52) aufweisen,
wobei der Verbindungsabschnitt (52) der jeweiligen Kontaktelektrode (12, 16, 20, 14, 18, 22) durch, insbesondere translatorisches, Biegen des Kontaktierungsabschnitts (26) und Verbindungsabschnitts (52) zum jeweiligen Mittelabschnitt (50) bei fixer Positionierung zur Gehäuseausnehmung (24) mit vier, insbesondere rechteckförmig angeordneten, Kontaktflächen (54) auf dem Substrat (36, 38) verbindbar ist.

2. Halbleitermodul (2) nach Anspruch 1,
wobei der Kontaktierungsabschnitt (26) und der Verbindungsabschnitt (52) jeweils um +/- 90° zum jeweiligen Mittelabschnitt (50) gebogen sind.

3. Halbleitermodul (2) nach einem der Ansprüche 1 oder 2, wobei der Kontaktierungsabschnitt (26) und/oder der Verbindungsabschnitt (52) zweier benachbarter Kontaktelektroden (12, 16, 20, 14, 18, 22) in unterschiedliche Richtungen gebogen sind.

4. Halbleitermodul (2) nach einem der vorherigen Ansprüche, wobei Mittelabschnitte (50) der Kontaktelektroden (12, 16, 20, 14, 18, 22) jeweils zumindest teilweise senkrecht zur Oberfläche (7) verlaufend angeordnet sind,
wobei eine, insbesondere rechteckige, Querschnittsfläche des jeweiligen Mittelabschnitts (50) einen Mittelpunkt (60) aufweist,
wobei die Mittelpunkte (60) der Kontaktelektroden (12, 16, 20, 14, 18, 22) in einem Raster angeordnet sind.

5. Halbleitermodul (2) nach Anspruch 4,
aufweisend sechs Kontaktelektroden (12, 16, 20; 14, 18, 22), wobei deren Mittelpunkte (60) in einem 3x2-Raster angeordnet sind.

6. Halbleitermodul (2) nach Anspruch 5,
wobei die jeweils vier, insbesondere rechteckförmig angeordneten, Kontaktflächen (54) der sechs Kontaktelektroden (12, 16, 20, 14, 18, 22) auf dem Substrat (36, 38) eine Fläche einschließen, welche mindestens 20 %, insbesondere 30 % einer stromführenden Substratfläche (40) beträgt.

7. Halbleitermodul (2) nach einem der Ansprüche 4 bis 6,
wobei die Kontaktflächen (54) ungleichmäßig auf einer stromführenden Substratfläche (40) verteilt sind.

8. Halbleitermodul (2) nach einem der Ansprüche 4 bis 6, wobei die Kontaktflächen (54) symmetrisch zu einer Längsmittelachse (44) einer stromführenden Substratfläche (40) angeordnet sind.

9. Halbleitermodul (2) nach einem der vorherigen Ansprüche, wobei die Halbleiterschaltung (34) zumindest ein, insbesondere rechteckiges, Steuersubstrat (42), welches auf der ebenen Oberfläche (7) der Wärmesenke (6) angeordnet ist, aufweist, wobei das zumindest eine Steuersubstrat (42) über Verdrahtungselemente (68) mit dem zumindest einen Substrat (36, 38) verbunden ist,
wobei eine Fläche des Steuersubstrats (42) maximal 15 %, insbesondere maximal 10 %, der Fläche des zumindest einen Substrats (36, 38) beträgt.

10. Halbleitermodul (2) nach Anspruch 9,
wobei das Steuersubstrat (42) zwischen zwei Befestigungslöchern (11) der Wärmesenke (6) angeordnet ist.

11. Halbleitermodul (2) nach einem der vorherigen Ansprüche, wobei die Halbleiterschaltung (34) Shunt-Widerstände (48) aufweist, welche auf dem Substrat (36, 38) kontaktiert sind, wobei die Halbleiterelemente (46) und die Shunt-Widerstände (48) symmetrisch zu einer Längsmittelachse (44) einer stromführenden Substratfläche (40) angeordnet sind.

12. Halbleitermodul (2) nach einem der vorherigen Ansprüche, wobei Halbleiterelemente (46) symmetrisch um zumindest eine Kontaktfläche (54) einer Kontaktelektrode (12, 16, 20, 14, 18, 22) auf dem Substrat (36, 38) angeordnet sind.

13. Halbleitermodul (2) nach einem der vorherigen Ansprüche, wobei die Halbleiterelemente (46) Transistoren (T) und Dioden (D) umfassen,
wobei die Dioden (D), bezogen auf eine Längsmittelachse (44), zwischen den Transistoren (T) angeordnet sind.

14. Stromrichter (72) mit mindestens einem Halbleitermodul (2) nach einem der vorherigen Ansprüche.

15. Verfahren zur Herstellung eines Halbleitermoduls (2) nach einem der Ansprüche 1 bis 13,
wobei die Kontaktelektroden (12, 16, 20, 14, 18, 22) als metallische Biegeteile (74) ausgeführt und mit einem gemeinsamen Stanzwerkzeug hergestellt werden.

16. Verfahren nach Anspruch 15,
wobei das Herstellen der Kontaktelektroden (12, 16, 20, 14, 18, 22) folgende Schritte umfasst:
- Ausrichten (A) des unsymmetrischen metallisches Biegeteils (74) bezüglich der Längsachse (76) anhand des L-förmigen Verbindungsabschnitts 52,
- erstes Biegen (B) des Kontaktierungsabschnitts (26) zum Mittelabschnitt (50) um eine erste Biegeachse (78),
- zweites Biegen (C) des L-förmigen Verbindungsabschnitts (52) um eine zweite Biegeachse (80).

17. Computerprogrammprodukt, umfassend Befehle, die bei einer Ausführung des Programms durch einen Computer diesen veranlassen, ein, insbesondere elektrisches, mechanisches und/oder thermisches, Verhalten eines Halbleitermoduls (2) nach einem der Ansprüche 1 bis 13 zu simulieren.
